Europäisches Patentamt

European Patent Office

Office européen des brevets

(11) Numéro de publication: **0 281 465 B1**

# (12) FASCICULE DE BREVET EUROPEEN

(45) Date de publication de fascicule du brevet: **06.05.92**   (51) Int. Cl.5: **G11C 7/06**, **H03K 5/02**

(21) Numéro de dépôt: **88400385.6**

(22) Date de dépôt: **19.02.88**

(54) Amplificateur de lecture pour mémoire.

(30) Priorité: **24.02.87 FR 8702371**

(43) Date de publication de la demande:
**07.09.88 Bulletin 88/36**

(45) Mention de la délivrance du brevet:
**06.05.92 Bulletin 92/19**

(84) Etats contractants désignés:
**AT BE CH DE ES FR GB IT LI NL**

(56) Documents cités:
**US-A- 4 110 641**

**IEEE INTERNATIONAL SOLID-STATE CIRCUITS CONFERENCE, vol. 28, conf. 32, 13 février 1985, pages 64-65,306, IEEE, Coral Gables, Florida, US; K. OCHII et al.: "A 17ns 64K CMOS RAM with a Schmitt trigger sense amplifier"**

**PATENT ABSTRACTS OF JAPAN, vol. 7, no. 64 (P-183)[1209], 17 mars 1983; & JP-A-57 208 690**

**ELECTRONIC DESIGN, vol. 33, no. 9, 18 avril 1985, pages 52-54, Hasbrouck Heights, New Jersey, US; D. BURSKY: "CMOS ICs handle high-voltage needs of RS-232 interface"**

(73) Titulaire: **SGS THOMSON MICROELECTRO-NICS SA**
**7, Avenue Galliéni**
**F-94250 Gentilly(FR)**

(72) Inventeur: **Calzi, Philippe**
**THOMSON-CSF SCPI 19, avenue de Messine**
**F-75008 Paris(FR)**

(74) Mandataire: **Ballot, Paul Denis Jacques et al**
**Cabinet Ballot-Schmit, 7, rue le Sueur**
**F-75116 Paris(FR)**

## Description

La présente invention concerne les circuits intégrés réalisés en technologie C-MOS (pour métal oxyde semiconducteur), plus particulièrement un amplificateur de lecture pour mémoire.

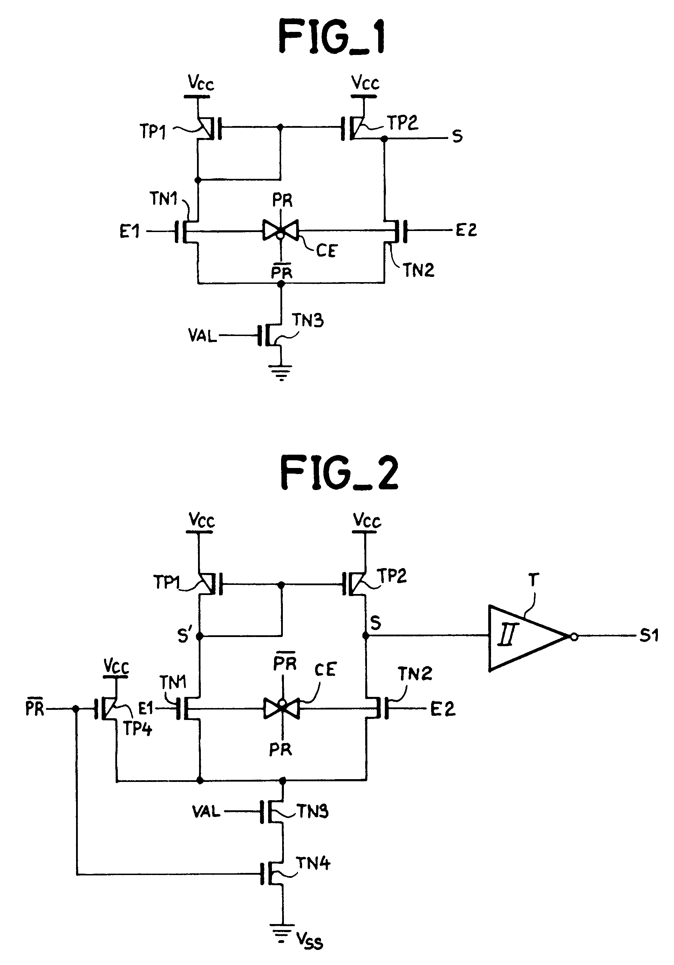

Dans les mémoires en circuit intégré telles que les mémoires RAM (pour random access memory en langue anglaise) ou similaires, la lecture des données enregistrées dans les cellules-mémoire est en général réalisée à l'aide d'amplificateurs différentiels. Comme représenté sur la figure 1 qui concerne un circuit réalisé en technologie C-MOS, les amplificateurs différentiels utilisés comprennent, selon un montage classique, une source d'alimentation en courant constituée par un transistor MOS de type N TN3 alimentant en parallèle deux groupes de transistors MOS en série constitués respectivement d'un transistor MOS de type N TN1 et d'un transistor MOS de type P TP1 d'une part et d'un transistor MOS de type N TN2 et d'un transistor MOS de type P TP2 d'autre part.

De manière plus spécifique, les deux groupes de transistors MOS TN1, TP1 et TN2, TP2 sont montés entre le drain du transistor MOS TN3 et la tension d'alimentation $V_{CC}$. Les grilles de commande des transistors TN1 et TN2 constituent les entrées E1 et E2 de l'étage différentiel. D'autre part, le montage décrit avec référence à la figure 1 est un schéma classique d'un étage différentiel à cinq transistors MOS à miroir du courant. Ainsi, le drain du transistor MOS TP1 est connecté avec sa grille de commande, elle-même connectée avec la grille de commande du transistor TP2. Dans ce cas, on obtient une seule sortie S non différentielle en tension, positive ou nulle. Cette sortie S est effectuée sur le drain du transistor TN2.

Cet étage différentiel comporte de plus un circuit d'équilibrage CE constitué de manière connue par une porte de transfert de type classique commandée par un signal de précharge PR et par son signal inversé $\overline{PR}$. Ce circuit permet, pendant une phase d'équilibrage réalisée avant chaque lecture, de positionner la sortie S de l'étage différentiel vers sa valeur en mode commun, c'est-à-dire vers la valeur prise par la tension de sortie lorsque les entrées E1 et E2 sont court-circuitées. Ce circuit d'équilibrage est essentiel dans les amplificateurs de lecture pour obtenir des temps d'accès très rapides.

Toutefois, ce circuit d'équilibrage présente un certain nombre d'inconvénients. En effet, si la valeur en mode commun correspond à un niveau logique "1" et que l'on doive lire en sortie successivement deux niveaux logiques "0", on aura donc sur la sortie S un signal présentant deux commutations, à savoir en début d'équilibrage une transition d'un niveau logique "0" à un niveau logique "1" suivie, au moment de la lecture, d'une transition d'un niveau logique "1" au niveau logique "0". Or, ceci entraîne une augmentation de la consommation du circuit et un risque de bruit sur les alimentations.

La présente invention a pour but de remédier à cet inconvénient en proposant un perfectionnement aux amplificateurs de lecture pour mémoire du type constitué par un étage différentiel comportant un circuit d'équilibrage. L'article IEEE INTERNATIONAL SOLID-STATE CIRCUITS CONFERENCE, vol. 28, conf. 32, 13 février 1985, pages 64-65, 306, IEEE Coral Gables, Florida, US;K. OCHII et al.: "A 17ns 64K CHOS RAM with a Schmitt trigger sense amplifier" décrit un amplificateur de lecture qui comporte toutes les caractéristiques du préambule de la revendication 1.
Il est connu de US-A-4 110 641 un comparateur en technologie CHOS constitué par un étage différentiel, ce comparateur comportant un amplificateur de sortie ayant une hystérésis.

En conséquence, la présente invention a pour objet un amplificateur de lecture pour mémoire en technologie C-MOS, cet amplificateur étant constitué par un étage différentiel comportant un circuit d'équilibrage mis en oeuvre pendant la phase d'équilibrage par un signal de précharge, caractérisé en ce que, en vue de maintenir pendant la phase d'équilibrage l'état de la sortie de l'étage différentiel, il est prévu un transistor MOS monté entre la tension d'alimentation et l'électrode reliée à la tension basse des transistors d'entrée de l'étage différentiel, la grille de ce transistor étant commandée par le signal de précharge.

Selon un mode de réalisation préférentiel, il est prévu en outre un amplificateur à seuil connecté en sortie de l'étage différentiel. De préférence, le transistor MOS est un transistor MOS de type P et l'amplificateur à seuil est un trigger de Schmitt.

Selon une autre caractéristique de la présente invention, pour éviter toute augmentation de la consommation du circuit, l'amplificateur de lecture comporte de plus des moyens permettant d'éviter cette surconsommation.

Selon un mode de réalisation préférentiel, ces moyens sont constitués par un transistor MOS monté en série entre la source de courant de l'étage différentiel et la masse, transistor MOS dont la grille est commandée par le signal de précharge.

D'autre caractéristiques et avantages de la présente invention apparaîtront à la lecture de la description d'un mode de réalisation, faite avec référence aux dessins ci-annexés dans lesquels :

- la figure 1, déjà décrite, représente un schéma d'un amplificateur de lecture selon l'art antérieur, et

- la figure 2 représente un schéma électrique d'un mode de réalisation préférentiel d'un amplificateur de lecture conforme à la présente invention.

Pour simplifier la description, dans les figures les mêmes éléments portent les mêmes références. D'autre part, la présente invention a été décrite en se référant à un mode de réalisation particulier d'un étage différentiel en technologie C-MOS, il est évident pour l'homme de l'art qu'elle peut aussi être utilisée avec d'autres modes de réalisation en technologie C-MOS.

Sur la figure 2 on a représenté un mode de réalisation d'un amplificateur de lecture pour mémoire conforme à la présente invention. Cet amplificateur de lecture comporte un étage différentiel ainsi qu'un circuit d'équilibrage, l'ensemble étant identique à l'amplificateur de lecture représenté sur la figure 1. De manière plus spécifique, l'étage différentiel comporte une source de courant réalisée par le transistor MOS de type N TN3 dont la grille est commandée par un signal de validation VAL.

Conformément à la présente invention, la source du transistor MOS TN3 est connectée à la masse ou à une tension basse $V_{ss}$ par l'intermédiaire d'un autre transistor MOS de type N TN4 dont le rôle sera expliqué de manière plus détaillée ci-après.

D'autre part l'étage différentiel comporte deux ensembles de transistors MOS montés en parallèle entre le drain du transistor TN3 et la tension d'alimentation $V_{cc}$. Ces deux ensembles sont constitués chacun par un transistor MOS de type N TN1 ou TN2 monté en série avec un transistor MOS de type P TP1 ou TP2. De manière plus spécifique, le drain de TN3 est connecté à la source du transistor MOS de type N TN1 dont le drain est connecté au drain du transistor MOS de type P TP1 ou TP2 dont la source est connectée à la tension d'alimentation.

D'autre part, les grilles des transistors MOS TN1 et TN2 reçoivent respectivement les signaux d'entrée E1 et E2 de l'étage différentiel. De plus, le montage représenté est un montage dit à miroir de courant. En conséquence, les grilles des transistors TP1 et TP2 sont connectées ensemble et le drain du transistor TP1 est connecté à sa grille. De ce fait, la sortie S de l'étage différentiel est obtenue sur le drain du transistor TP2.

Le circuit d'équilibrage CE est constitué par une porte de transfert de type connu connectée entre les grilles des transistors TN1 et TN2 et recevant le signal de précharge PR et son signal inversé $\overline{PR}$.

Conformément à la présente invention, un transistor MOS de type P TP4 est monté entre la tension d'alimentation $V_{cc}$ et la source des transistors TN1 et TN2, c'est-à-dire l'électrode reliée à la tension basse des transistors d'entrée de l'étage différentiel. La grille du transistor MOS TP4 est comandée par le signal de précharge inversé $\overline{PR}$. D'autre part, le signal de précharge inversé $\overline{PR}$ commande aussi la grille du transistor MOS de type N TN4 monté entre la source du transistor MOS TN3 et la tension basse $V_{ss}$.

Selon une autre caractéristique de la présente invention un amplificateur à seuil tel qu'un trigger de Schmitt T est relié à la sortie S de l'étage différentiel.

On expliquera maintenant le fonctionnement de l'amplificateur de lecture pour mémoire conforme à la présente invention.

Pendant la phase d'équilibrage, à savoir lorsque le signal $\overline{PR}$ est au niveau logique "0", le transistor MOS TN4 est bloqué ce qui permet de couper l'alimentation et évite ainsi une surconsommation. En même temps le transistor MOS TP4 devient passant et impose un potentiel égal à la tension d'alimentation $V_{cc}$ sur les sources des transistors d'entrée TN1 et TN2. En conséquence, les transistors TN1 et TN2 sont bloqués par effet substrat. De ce fait, les points S et S' sont isolés de la tension basse $V_{ss}$ en ne peuvent évoluer que grâce à l'action des transistors MOS TP1 et TP2.

En fait, le transistor TP1 est monté en résistance. Aussi le potentiel S' est imposé par ce montage et quel que soit le niveau de la sortie S, la tension VS' sera dans les deux cas sensiblement équivalente. Comme on utilise un miroir de courant, les courants dans les deux branches de l'amplificateur différentiel seront les mêmes, il en sera donc de même pour la variation de tension, d'où les équations :

$$VS\,(2) = VS\,(1) + \Delta VS$$

$$VS'\,(2) = VS'\,(1) + \Delta VS'$$

avec

$$\Delta VS = \Delta VS' = VS'\,(2) - VS'(1)$$

Ainsi, dans un circuit réalisé en technologie C-MOS, 2 microns dans lequel les transistors TP1 et TP2 ont été choisis de telle sorte que leur rapport W/L = 30/2,5 et les transistors TN1 et TN2 ont été choisis de telle sorte que leur rapport W/L = 25/2, si la sortie S est au niveau logique "1", l'on obtient avec une tension d'alimentation $V_{cc}$ de 5 volts :
VS (1) ≃ 4,8 volts et VS' (1) ≃ 3,2 volts ;
si la sortie S' est au niveau logique "0", l'on obtient :
VS (1) ≃ 0,8 volt et VS' (1) ≃ 3,5 volts

Dans le premier cas, lors de la précharge, la source des transistors TN1 et TN2 est placée sensiblement à $V_{cc}$ et les entrées E1 et E2 sont court-circuitées. Dans ce cas :

VS' (2) → $V_{cc}$ - VTP

d'où : VS' (2)≈4,4 volts

VS (2) → VS (1) + VS' (2) - VS' (1)

d'où : VS (2)≈$V_{cc}$

Dans le deuxième cas, lors de la précharge :

VS' (2)→$V_{cc}$ - |VTP|

d'où : VS' (2)≈4,4 volts

VS (2)→VS (1) + VS' (2) - VS' (1)

d'où : VS (2)≈1,7 volt

Comme représenté sur la figure 2, pour obtenir sur la sortie S1 un niveau haut et un niveau bas bien déterminés, S est connecté à un trigger de Schmitt T qui commute pour une tension d'environ 3,0 volts. De ce fait, le niveau bas 1,7 volt sera vu comme un niveau logique 0.

**Revendications**

1. Amplificateur de lecture pour mémoires en technologie C-MOS, du type constitué par un étage différentiel (TN1, TP1, TN2, TP2, TN3) comportant un circuit d'équilibrage pour équilibrer les tensions aux entrées de l'étage différentiel (CE) mis en oeuvre pendant la phase d'équilibrage par un signal de précharge (PR), caractérisé en ce que, en vue de maintenir pendant la phase d'équilibrage l'état de la sortie (S) de l'étage différentiel, il est prévu un transistor MOS (TP4) monté entre la tension d'alimentation et l'électrode reliée à la tension basse des transistors d'entrée de l'étage différentiel, la grille de ce transistor étant commandée par le signal de précharge.

2. Amplificateur de lecture selon la revendication 1, caractérisé en ce que le transistor MOS (TP4) est un transistor MOS de type P.

3. Amplificateur de lecture selon l'une des revendications 1 et 2, caractérisé en ce qu'il est prévu en outre un amplificateur à seuil (T) connecté en sortie de l'étage différentiel.

4. Amplificateur de lecture selon la revendication 3, caractérisé en ce que l'amplificateur à seuil (T) est un trigger de Schmitt.

5. Amplificateur de lecture selon l'une quelconque des revendications 1 à 4, caractérisé en ce qu'il comporte de plus des moyens (TN4) pour éviter une surconsommation de courant.

6. Amplificateur de lecture selon la revendication 5, caractérisé en ce que les moyens pour éviter une surconsommation de courant sont constitués par un transistor MOS monté en série entre une source de courant (TN3) de l'étage différentiel et la masse, la grille de ce transistor étant commandée par le signal de précharge (PR).

**Claims**

1. A read amplifier for C-MOS technology memories constituted by a differential stage (TN1, TP1, TN2, TP2 and TN3) comprising a balancing circuit (CE) in order to balance the voltages at the inputs of the differential stage and put into operation during the balancing phase by a bias signal (PR), characterized in that for the purpose of holding, during the balancing phase, the state of the output (S) of the differential stage an MOS transistor (TP4) is provided arranged between the feed voltage and the electrode connected with the low voltage of the input transistors of the differential stage, the gate of this transistor being controlled by the bias signal.

2. The read amplifier as claimed in claim 1, characterized in that the MOS transistor (TP4) is a P type MOS transistor.

3. The read amplifier as claimed in either of the claims 1 and 2, characterized in that it is furthermore provided with a threshold amplifier (T) connected in series with the differential stage.

4. The read amplifier as claimed in claim 3, characterized in that the threshold amplifier (T) is a Schmitt trigger.

5. The read amplifier as claimed in any one of the preceding claims 1 through 4, characterized in that it furthermore comprises means (TN4) in order to avoid overly high consumption of current.

6. The read amplifier as claimed in claim 5, characterized in that the means in order to avoid overly high consumption of current are constituted by an MOS transistor arranged in series between the a current source (TN3) of the differential stage and ground, the gate of this transistor being controlled by the bias signal (PR)

**Patentansprüche**

1. Leseverstärker für Speicher in CMOS-Technologie von einer Bauart, die von einer Differentialstufe (TN1, TP1, TN2, TP2, TN3) aufgebaut wird, die eine Ausgleichsschaltung (CE) zum Ausgleichen der Spannungen an den Eingängen der Differentialstufe umfaßt, welche in der Ausgleichsphase von einem Vorladungssignal (PR) aktiviert wird, dadurch gekennzeichnet, daß für die Aufrechterhaltung des Zustandes des Ausgangs (S) der Differentialstufe während der Ausgleichsphase ein MOS-Transistor (TP4) vorgesehen ist, der zwischen der Versorgungsspannung und der mit der niedrigen Spannung der Eingangstransistoren der Differentialstufe verbundenden Elektrode angebracht ist, wobei das Gate dieses Transistors vom Vorladungssignal gesteuert wird.

2. Leseverstärker gemäß Anspruch 1, dadurch gekennzeichnet, daß der MOS-Transistor (TP4) ein P-MOS- Transistor ist.

3. Leseverstärker gemäß einem der Ansprüche 1 und 2, dadurch gekennzeichnet, daß außerdem ein mit dem Ausgang der Differentialstufe verbundender Schwellenwertverstärker (T) vorgesehen ist.

4. Leseverstärker gemäß Anspruch 3, dadurch gekennzeichnet, daß der Schwellenwertverstärker (T) ein Schmitt-Trigger ist.

5. Leseverstärker gemäß einem der Ansprüche 1 bis 4, dadurch gekennzeichnet, daß er außerdem Mittel (TN4) umfaßt, um einen erhöhten Stromverbrauch zu vermeiden.

6. Leseverstärker gemäß Anspruch 5, dadurch gekennzeichnet, daß die Mittel zum Vermeiden erhöhten Stromverbrauchs von einem MOS-Transistor gebildet werden, der zwischen einer Stromquelle (TN3) der Differentialstufe und Masse in Reihe geschaltet ist, wobei das Gate dieses Transistors vom Vorladungssignal (PR) gesteuert wird.

# FIG_1

# FIG_2